# EUROPEAN PATENT APPLICATION

(11) **EP 2 674 989 A2**
(43) Date of publication of application: **18.12.2013**
(21) Application number: 13171272.1
(22) Date of filing: 10.06.2013
(51) Int. Cl.: H01L 31/052, E06B 3/67

(54) **Power generating window set and power generating module thereof**

(30) Priority: 15.06.2012 CN 201210204146; 31.07.2012 TW 101214734; 28.12.2012 TW 101150790
(71) Applicant: Chi Lin Technology Co., Ltd., 71758 Rende Dist., Tainan City (TW)
(72) Inventor: Tsai, Jung-Lieh, 71758 Rende Dist., Tainan City (TW); Chiang, Yi-Hsing, 71758 Rende Dist., Tainan City (TW); Chang, Te-Hung, 71758, Rende Dist., Tainan City (TW); Lee, Meng-Chung, 71758 Rende Dist., Tainan City (TW); Fan, Cho-Han, 71758 Rende Dist., Tainan City (TW); Hu, Chiang-Rong, 71758 Rende Dist., Tainan City (TW)
(74) Representative: 2K Patentanwälte Blasberg Kewitz & Reichel

(57) **Abstract**

The present invention relates to a power generating window set and a power generating module thereof. The power generating module includes a light-guiding substrate and at least one photoelectric conversion element. The light-guiding substrate has a plurality of microstructures. The photoelectric conversion element is disposed adjacent to the light-guiding substrate. When a light beam illuminates the light-guiding substrate, the microstructures guide a part of the light beam to the photoelectric conversion element, so as to convert the energy of part of the light beam into electrical energy.

## Description

### BACKGROUND OF THE INVENTION

### 1. Field of the Invention

The present invention relates to a power generating window set and power generating module thereof, and more particularly to a power generating module having microstructures and a power generating window set including the power generating module.

### 2. Description of the Related Art

The conventional power generating window set includes a plurality of solar cells attached to a light incident surface or a light emitting surface of a glass plate, so as to collect sunlight beam and generate electrical power. However, the light transmittance of the solar cell is relative low, such that the light transmittance of the glass plate is low as the solar cells are attached to the glass plate. Therefore, in real practice, the conventional power generating window set will block most of the sunlight beam, such that the user can not see through the glass plate clearly because of sight obstruction, and the indoor illumination is reduced.

Therefore, it is necessary to provide a power generating window set and power generating module thereof to solve the above problems.

### SUMMARY OF THE INVENTION

The present invention is directed to a power generating module, which comprises a light-guiding substrate and at least one photoelectric conversion element. The light-guiding substrate has a first surface, a second surface and a plurality of microstructures. The first surface is adjacent to or opposite to the second surface. The photoelectric conversion element is disposed adjacent to or onto the light-guiding substrate. When a light beam illuminates the light-guiding substrate, the microstructures guide a part of the light beam to the at least one photoelectric conversion element, so as to convert the energy of the part of the light beam into electrical energy. Meanwhile, another part of the light beam passes through the light-guiding substrate directly. Therefore, when the power generating module is applied to a window set, it will not cause the sight obstruction, and the light beam can pass through the power generating module without decreasing the indoor illumination. In addition, the microstructures may be produced by laser machining, which is a simple manufacturing process.

The present invention is further directed to a power generating window set, which comprises a first light transmissible plate, a second light transmissible plate, and at least one above-mentioned power generating module. The second light transmissible plate is opposite to the first light transmissible plate. The light-guiding substrate is disposed between the first light transmissible plate and the second light transmissible plate. The first light transmissible plate and the second light transmissible plate can support and protect the light-guiding substrate.

### BRIEF DESCRIPTION OF THE DRAWINGS

FIG. 1 is a perspective view of a power generating module according to an embodiment of the present invention.
FIG. 2 is a front view of the power generating module of FIG. 1.
FIG. 3 is a cross sectional view taken along line 3-3 of FIG. 2.
FIG. 4 is another example of the microstructures of FIG. 3.
FIG. 5 is a cross sectional view taken along line 5-5 of FIG. 2.
FIG. 6 is a perspective view of a power generating module according to another embodiment of the present invention.
FIG. 7 is a perspective view of a power generating module according to another embodiment of the present invention.
FIG. 8 is a perspective view of a power generating module according to another embodiment of the present invention.
FIG. 9 is a schematic view of a first testing for the power generating module of the present invention.
FIG. 10 shows the illumination measured by the sensors disposed at different vertical positions along the vertical direction according to the first testing of FIG. 9.
FIG. 11 shows the illumination measured by the sensors disposed at different horizontal positions along the horizontal direction according to the first testing of FIG. 9.
FIG. 12 is a schematic view of a second testing for the power generating module of the present invention.
FIG. 13 shows the illumination measured by the sensors disposed at different vertical positions along the vertical direction according to the second testing of FIG. 12.
FIG. 14 shows the illumination measured by the sensors disposed at different horizontal positions along the horizontal direction according to the second testing of FIG. 12.
FIG. 15 is a side view of a power generating window set according to an embodiment of the present invention.
FIG. 16 is a side view of a power generating window set according to another embodiment of the present invention.
FIG. 17 is a front view of a power generating window set according to another embodiment of the present invention.
FIG. 18 is a perspective view of a power generating module according to another embodiment of the present invention.
FIG. 19 is an enlarged partially cross sectional view of the power generating module of FIG. 18.
FIG. 20 shows the light paths of a part of the light beam of the power generating module of FIG. 18.
FIG. 21 is a perspective view a power generating module according to another embodiment of the present invention.
FIG. 22 is a cross sectional view of a power generating module according to another embodiment of the present invention.
FIG. 23 is a perspective view of a power generating module according to another embodiment of the present invention.
FIG. 24 is an enlarged partially cross sectional view of the power generating module in FIG. 23.
FIG. 25 is the light paths of a part of the power generating module in FIG. 23.
FIG. 26 is a perspective view of a power generating module according to another embodiment of the present invention.
FIG. 27 is a cross sectional view of a power generating module according to another embodiment of the present invention.
FIG. 28 is a schematic view of an application of simulating the power generating module of the present invention by utilizing a test instrument.
FIG. 29 shows simulation results of light-guiding substrates with different patterns by using the test instrument of FIG. 28.
FIG. 30 is a perspective view of a power generating module according to another embodiment of the present invention.
FIG. 31 is a perspective view of a power generating module according to another embodiment of the present invention.
FIG. 32 is a front view of a power generating module according to another embodiment of the present invention.
FIG. 33 is a cross sectional view taken along line 33-33 of FIG. 32.
FIG. 34 is another pattern of the microstructure of FIG. 33.
FIG. 35 is another pattern of the microstructure of FIG. 33.
FIG. 36 is a front view of a power generating module according to another embodiment of the present invention.
FIG. 37 is a front view of a power generating module according to another embodiment of the present invention.
FIG. 38 is a front view of a power generating module according to another embodiment of the present invention.
FIG. 39 is a front view of a power generating module according to another embodiment of the present invention.
FIG. 40 is a front view of a power generating module according to another embodiment of the present invention.
FIG. 41 shows a schematic view of another testing environment of a power generating module of the present invention.
FIG. 42 is a diagram of test results of the light-guiding substrate in FIG. 36 under different microstructure density.
FIG. 43 is a diagram of test results of light-guiding substrates with the microstructure density still being 19.5% but having different microstructure distribution patterns.
FIG. 44 is a diagram of optical simulation results when light-guiding substrates with different microstructure density are illuminated by incident light with different incident angles.
FIG. 45 is a perspective view of a power generating module according to another embodiment of the present invention.
FIG. 46 is a front view of a power generating module according to another embodiment of the present invention.
FIG. 47 is a side view of a power generating window set according to another embodiment of the present invention.

### DETAILED DESCRIPTION OF THE INVENTION

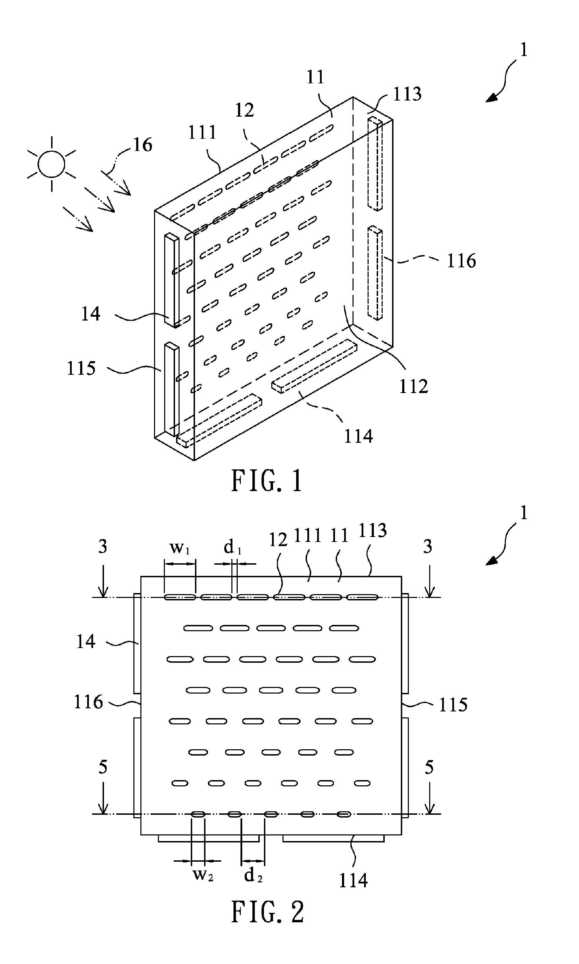

FIG. 1 shows a perspective view of a power generating module according to an embodiment of the present invention. FIG. 2 shows a front view of the power generating module of FIG. 1. The power generating module 1 comprises a light-guiding substrate 11 and at least one photoelectric conversion element 14. The light-guiding substrate 11 has a first surface 111, a second surface 112, a third surface 115, a fourth surface 116, a fifth surface 113, a sixth surface 114 and a plurality of microstructures 12. Preferably, the material of the light-guiding substrate 11 is light transmissible, such as glass or light transmissible plastic plate.

The first surface 111 is adjacent to or opposite to the second surface 112. In this embodiment, the first surface 111 is opposite to the second surface 112, and adjacent to the third surface 115, the fourth surface 116, the fifth surface 113 and the sixth surface 114. The fifth surface 113 (e.g., top surface) is opposite to the sixth surface 114 (e.g., bottom surface), and the third surface 115 is opposite to the fourth surface 116. The microstructures 12 are recessed from the first surface 111 of the light-guiding substrate 11. That is, the microstructures 12 are recessed in the light-guiding substrate 11 from the first surface 111.

In this embodiment, the microstructures 12 are disposed on the first surface 111 and have openings on the first surface 111. The microstructures 12 extend from the first surface 111 toward the second surface 112. Each of the microstructures 12 is in elliptical shape from its top view, and is formed by, e.g., laser machining. The shape of the opening of the microstructure 12 is not limited to elliptical shape, and can be various shapes (e.g., circular shape, rectangular shape or polygonal shape) formed by other manufacturing processes. The microstructures 12 are not connected to each other, that is, the edges of the openings of the microstructures 12 on the first surface 111 do not contact each other. The microstructures 12 may be distributed unevenly, for example, microstructure with large opening width and microstructure with small opening width may be arranged alternatively, or the microstructures may be arranged in sequence from large opening width to small opening width. The arrangement direction is not limited, for example, it may be from the third surface 115 to the fourth surface 116, or from the fifth surface 113 to the sixth surface 114. The distances between the microstructures 12 are not equal to each other. That is, the gaps between the edges of the openings of the microstructures 12 on the first surface 111 are not equal to each other, and the density of the microstructures 12 is not even.

In addition, each of the microstructures 12 has an opening width, and the opening widths are not equal to each other. Taking FIG. 2 for example, each of the microstructures 12 near the fifth surface 113 has an opening width W₁, and each of the microstructures 12 near the sixth surface 114 has an opening width W₂, wherein the opening width W₁ is greater than the opening width W₂. Meanwhile, the gap d₁ between the microstructures 12 near the fifth surface 113 is less than the gap d₂ between the microstructures 12 near the sixth surface 114. Therefore, the brightness of the light beam guided to the photoelectric conversion element 14 from a light source (not labeled) can be adjusted by using the design of different density of the microstructures 12.

The photoelectric conversion element 14 is disposed adjacent to the light-guiding substrate 11 or disposed on the light-guiding substrate 11. Preferably, the photoelectric conversion element 14 is a solar cell. In this embodiment, the photoelectric conversion elements 14 are adhered or attached directly to the sixth surface 114, the third surface 115 and the fourth surface 116, and the light receiving surfaces of the photoelectric conversion elements 14 face toward the sixth surface 114, the third surface 115 and the fourth surface 116. However, in other embodiment, the photoelectric conversion elements 14 may be disposed at other positions.

In operation, when a light beam 16 (e.g., sunlight beam) illuminates the light-guiding substrate 11, the microstructures 12 guide a part of the light beam 16 to the photoelectric conversion element 14, so as to convert the energy of the part of the light beam 16 into electrical energy. In this embodiment, when the light beam 16 (e.g., sunlight beam) arrives at the first surface 111, the microstructures 12 guide a part of the light beam 16 to the photoelectric conversion element 14, so as to convert the energy of the part of the light beam 16 into electrical energy. Meanwhile, another part of the light beam 16 passes through the light-guiding substrate 11 directly. Therefore, when the power generating module 1 is applied to a window set, it will not cause the sight obstruction, and the light beam 16 can pass through the power generating module 1 without influencing the indoor illumination. In addition, the microstructures 12 may be formed by laser machining, which is a simple manufacturing process. However, the manufacturing process of the microstructures 12 also includes, but not limited to, imprinting, injection, milling process and etching.

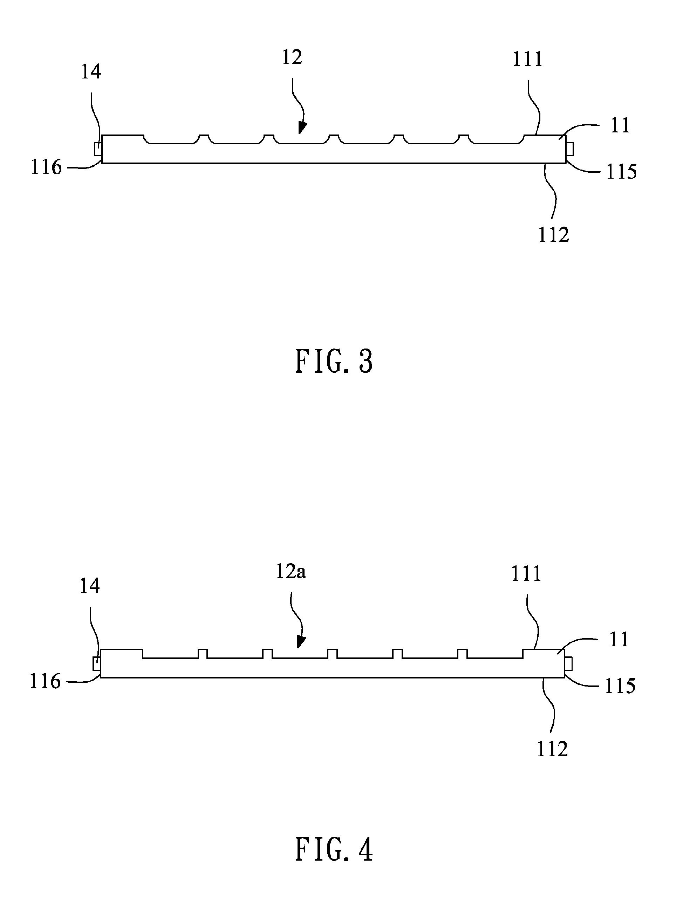

FIG. 3 shows a cross sectional view taken along line 3-3 of FIG. 2. As shown in this figure, each of the recessed microstructures 12 has a curved profile.

FIG. 4 shows another example of the microstructures of FIG. 3. As shown in this figure, each of the recessed microstructures 12a is a groove with rectangular profile.

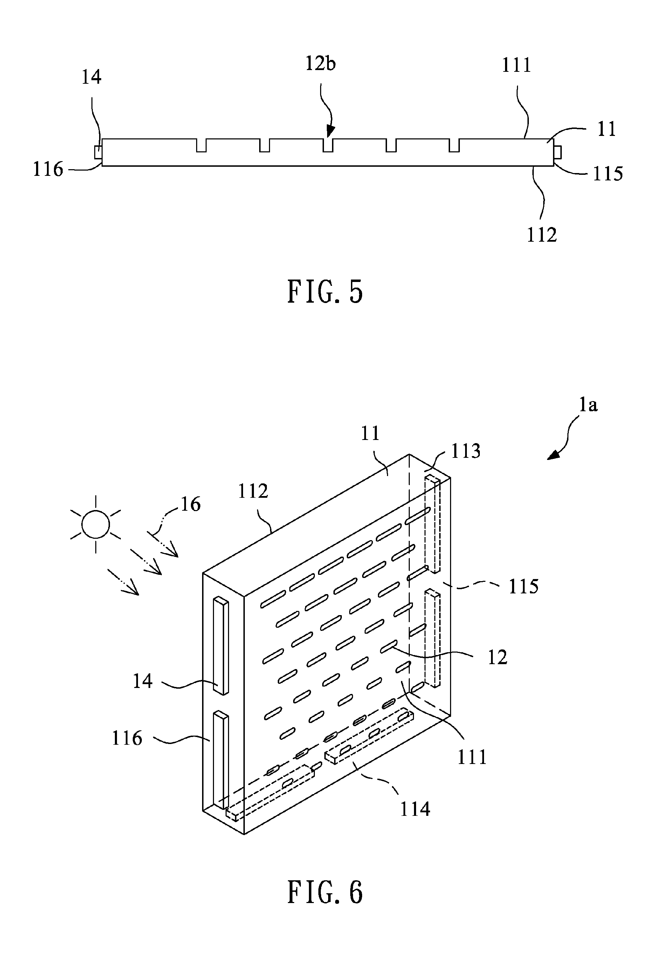

FIG. 5 shows a cross sectional view taken along line 5-5 of FIG. 2. As shown in this figure, each of the recessed microstructures 12b has a split profile.

FIG. 6 shows a perspective view of a power generating module according to another embodiment of the present invention. The power generating module 1a of this embodiment is similar to the power generating module 1 of FIG. 1, and the difference lies in that, in this embodiment, the power generating module 1 is turned 180 degrees. Therefore, in the power generating module 1a, the second surface 112 of the light-guiding substrate 11 faces toward the light beam 16. That is, the light beam 16 passes through the second surface 112 before arriving at the first surface 111. As stated above, when the light beam 16 arrives at the first surface 111, the microstructures 12 guide a part of the light beam 16 to the photoelectric conversion element 14, so as to convert the energy of the part of the light beam 16 into electrical energy.

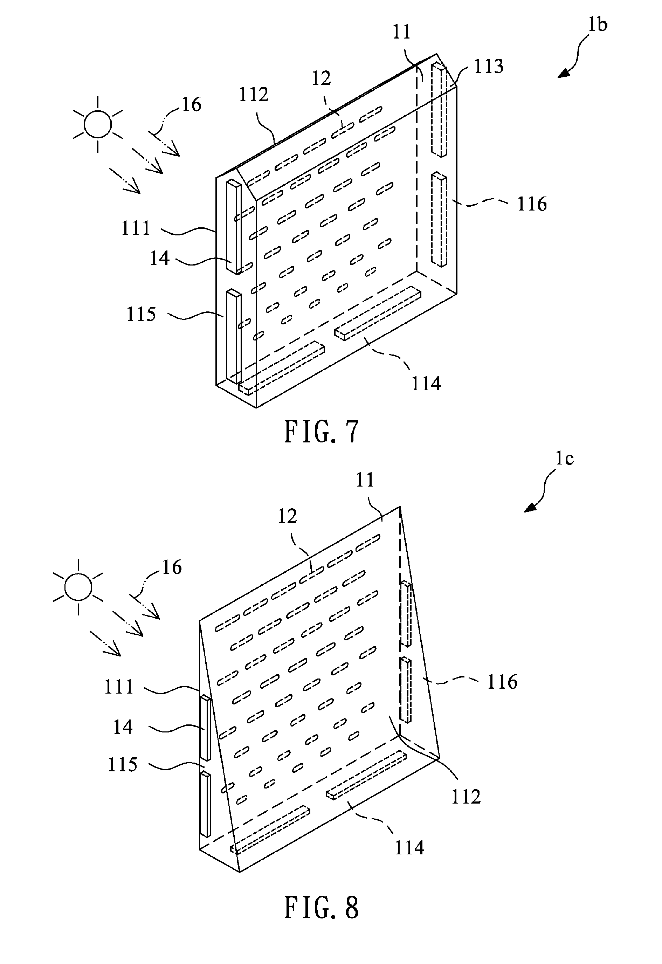

FIG. 7 shows a perspective view of a power generating module according to another embodiment of the present invention. The power generating module 1b of this embodiment is similar to the power generating module 1 of FIG. 1, and the difference lies in that, in this embodiment, the light-guiding substrate 11 has a protrusion. Thus, the light-guiding substrate 11 is a pentangle from side view, and the first surface 111 is adjacent to the second surface 112.

FIG. 8 shows a perspective view of a power generating module according to another embodiment of the present invention. The power generating module 1c of this embodiment is similar to the power generating module 1 of FIG. 1, and the difference lies in that, in this embodiment, the light-guiding substrate 11 is a triangle from side view, and the first surface 111 is adjacent to the second surface 112.

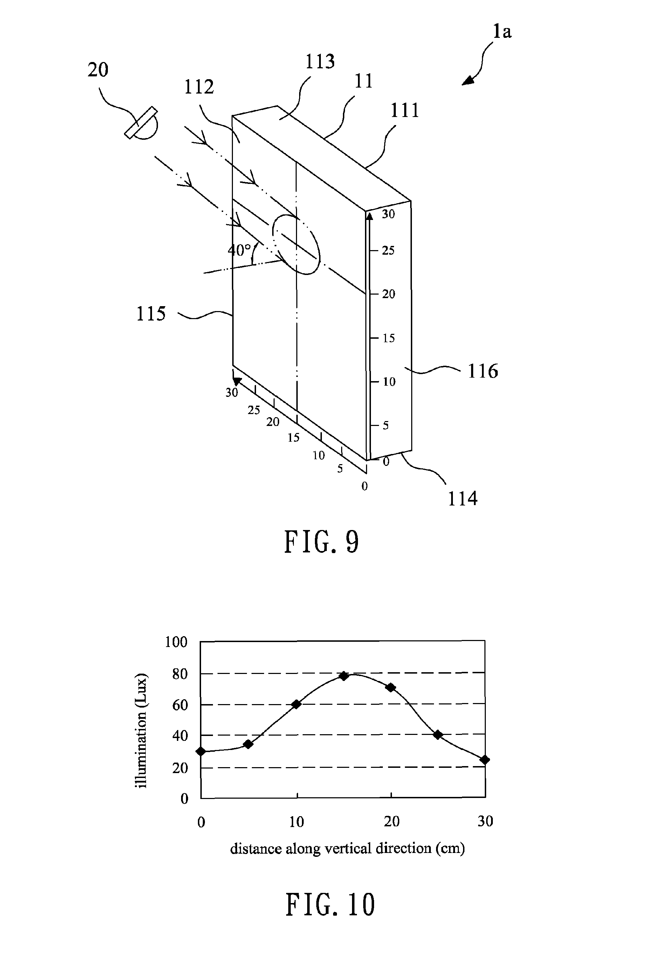

FIG. 9 shows a schematic view of a first testing for the power generating module of the present invention. In this testing, the power generating module 1a of FIG. 6 is tested, and a LED 20 with 3.5W is used as the light source. In order to ensure the light guiding effect of the microstructures, the LED 20 is mounted with a sleeve (not shown) so that the LED 20 can only illuminate the second surface 112 of the light-guiding substrate 11. The sensors (not shown) are disposed on the sixth surface 114 and the fourth surface 116 to perform measurement. The size of the light-guiding substrate 11 is as follows, length: 30 cm, width: 30 cm, thickness: 0.6 cm. The background illumination of the testing circumstance is below 4 lux. That is, when the LED 20 is turned off, the illumination measured by the sensors is lower than 4 lux.

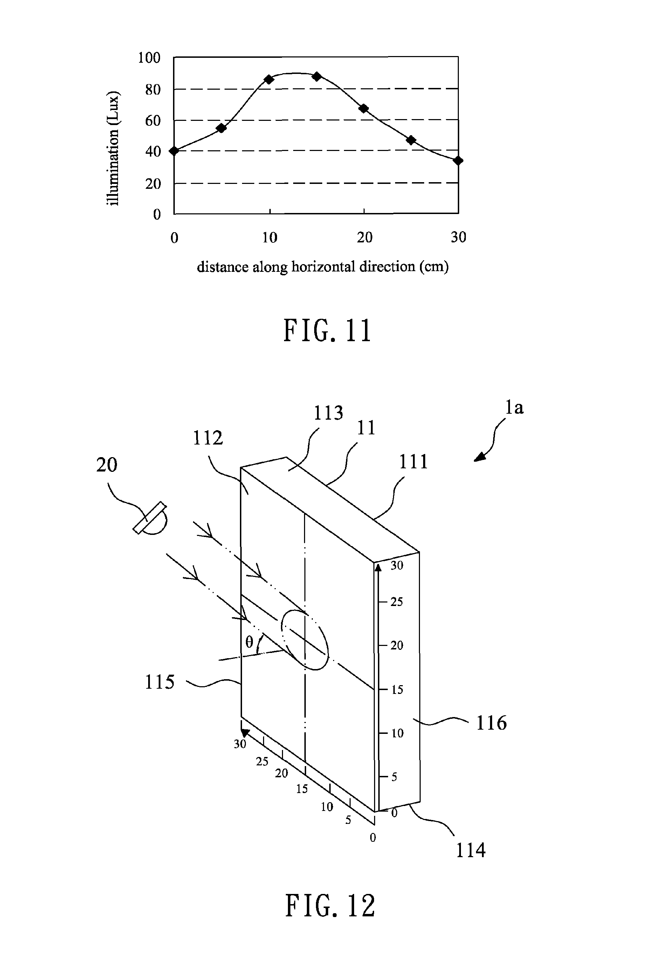

When the LED 20 is turned on, it illuminates the area slightly higher than the center of the second surface 112 of the light-guiding substrate 11, and the incident angle is 40 degrees, wherein the incident angle is defined as the inclination angle between the incident light and the normal line of the second surface 112. The illumination measured by the sensors disposed at different vertical positions along the vertical direction of the fourth surface 116 is shown in FIG. 10. The illumination measured by the sensors disposed at different horizontal positions along the horizontal direction of the sixth surface 114 is shown in FIG. 11. As shown in FIGs. 10 and 11, the illuminations of the fourth surface 116 and the sixth surface 114 are both greater than the background illumination, which means that the microstructures 12 can guide the incident light beam to the fourth surface 116 and the sixth surface 114 efficiently. It is to be noted that the fourth surface 116 and the sixth surface 114 of FIG. 9 are used as examples for measurement, and the microstructures 12 do not only guide the incident light beam to the fourth surface 116 and the sixth surface 114. The microstructures 12 can also guide the incident light beam to the third surface 115.

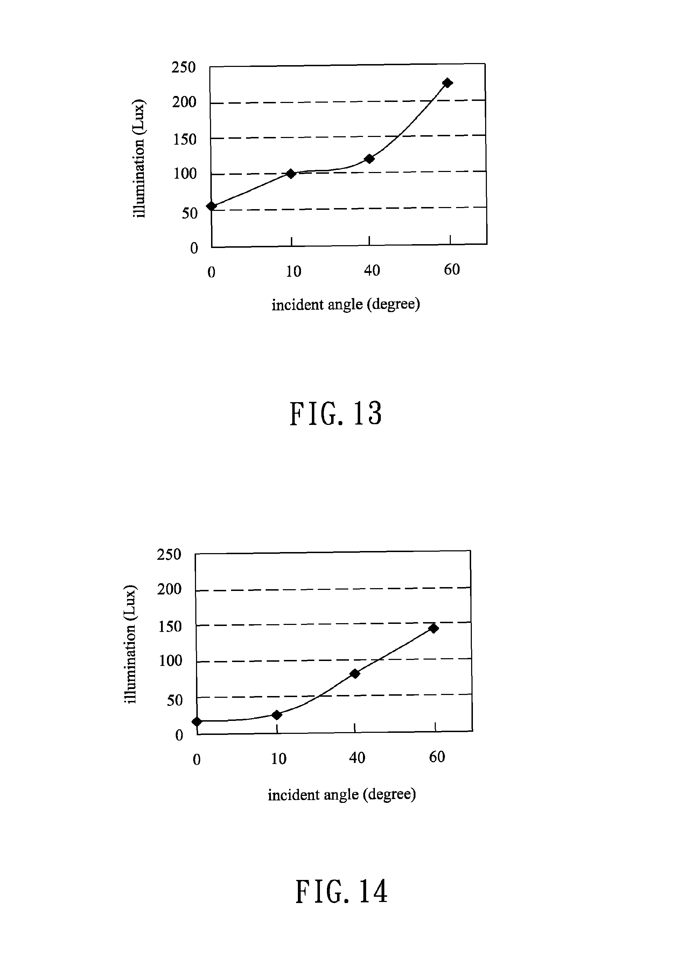

FIG. 12 shows a schematic view of a second testing for the power generating module of the present invention. The testing circumstance and testing conditions of this testing are the same as that of the first testing of FIG. 9. The difference is that, in this testing, when the LED 20 is turned on, it illuminates the center of the second surface 112 of the light-guiding substrate 11, and the incident angle θ is a variable parameter, wherein the incident angle θ is defined as the inclination angle between the incident light and the normal line of the second surface 112. The illumination measured by the sensors disposed on the sixth surface 114 under different incident angles is shown in FIG. 13. The illumination measured by the sensors disposed on the fourth surface 116 under different incident angles is shown in FIG. 14. It is to be noted that the fourth surface 116 and the sixth surface 114 of FIG. 12 are used as examples for measurement, and the microstructures 12 do not only guide the incident light beam to the fourth surface 116 and the sixth surface 114. The microstructures 12 can also guide the incident light beam to the third surface 115.

As shown in FIGs. 13 and 14, the illuminations of the fourth surface 116 and the sixth surface 114 are both greater than the background illumination, which means that the microstructures 12 can guide the incident light beam to the fourth surface 116 and the sixth surface 114 efficiently. The illumination is outstandingly increased when the incident angle θ is 40 degrees to 60 degrees, which means the increase of the incident angle θ will also increase the light guiding effect of the structure of the present invention. When the sunlight illuminates the power generating module of the present invention, the power generating module is fit for the distribution curve of the solar energy in one day, so as to solve the problem of poor light concentrating effect caused by the increase of incident sunlight due to the daily movement of the sun.

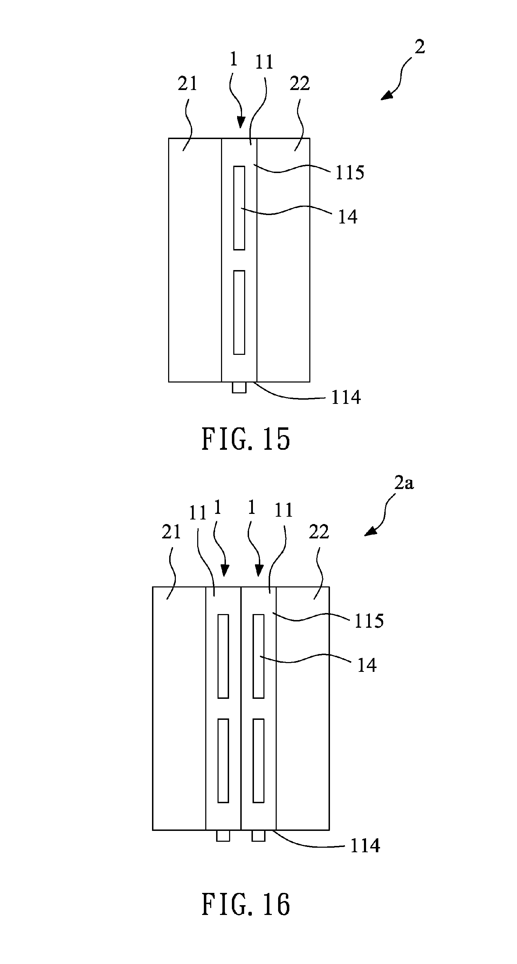

FIG. 15 shows a side view of a power generating window set according to an embodiment of the present invention. The power generating window set 2 comprises a first light transmissible plate 21, a second light transmissible plate 22 and at least one power generating module 1. The second light transmissible plate 22 is opposite to the first light transmissible plate 21. The power generating module 1 is the same as the above-mentioned power generating module 1 (FIG.1 and FIG. 2), and includes the light-guiding substrate 11 and the photoelectric conversion element 14. The light-guiding substrate 11 is disposed adjacent to the first light transmissible plate 21 or the second light transmissible plate 22. In this embodiment, the light-guiding substrate 11 is disposed between the first light transmissible plate 21 and the second light transmissible plate 22. The first light transmissible plate 21 and the second light transmissible plate 22 can support and protect the light-guiding substrate 11.

FIG. 16 shows a side view of a power generating window set according to another embodiment of the present invention. The power generating window set 2a of this embodiment is similar to the power generating window set 2 of FIG. 15, and the difference lies in that, in this embodiment, the power generating window set 2a comprises two light-guiding substrates 11, and the light-guiding substrates 11 are parallel to each other. Preferably, the patterns of the microstructures on the light-guiding substrates 11 are different, or the patterns are the same but the direction of recession of the microstructures are different.

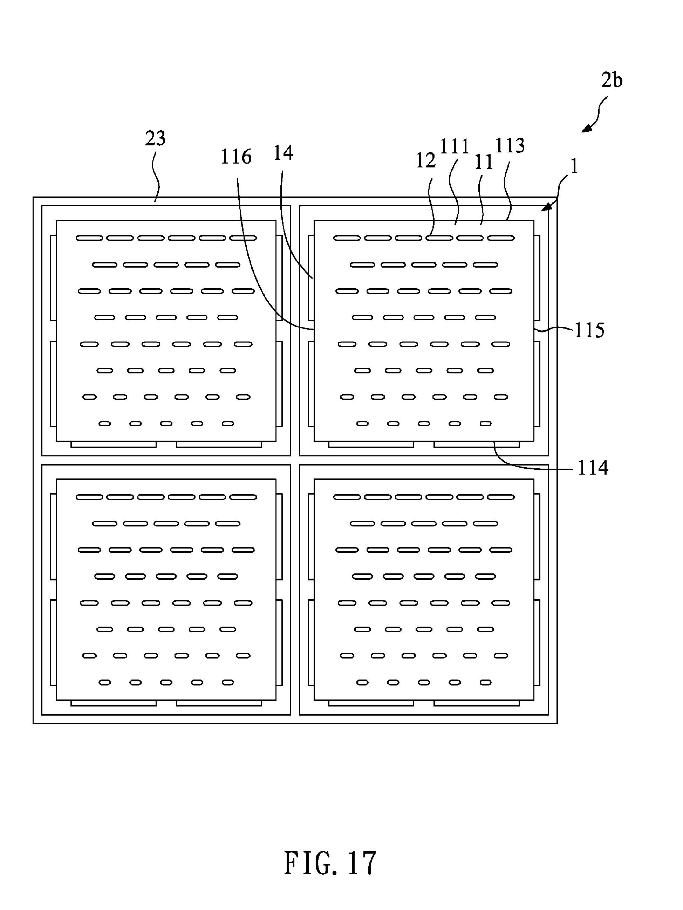

FIG. 17 shows a front view of a power generating window set according to another embodiment of the present invention. The power generating window set 2b of this embodiment is similar to the power generating window set 2 of FIG. 15, and the difference lies in that, in this embodiment, the power generating window set 2b comprises a window frame 23 and four light-guiding substrates 11. The window frame 23 has an outer rim and an inner cross-shaped element, wherein the inner cross-shaped element is fixed to the outer rim so as to define four accommodating spaces. The four light-guiding substrates 11 are disposed in the four accommodating spaces respectively, and are in the same plane.

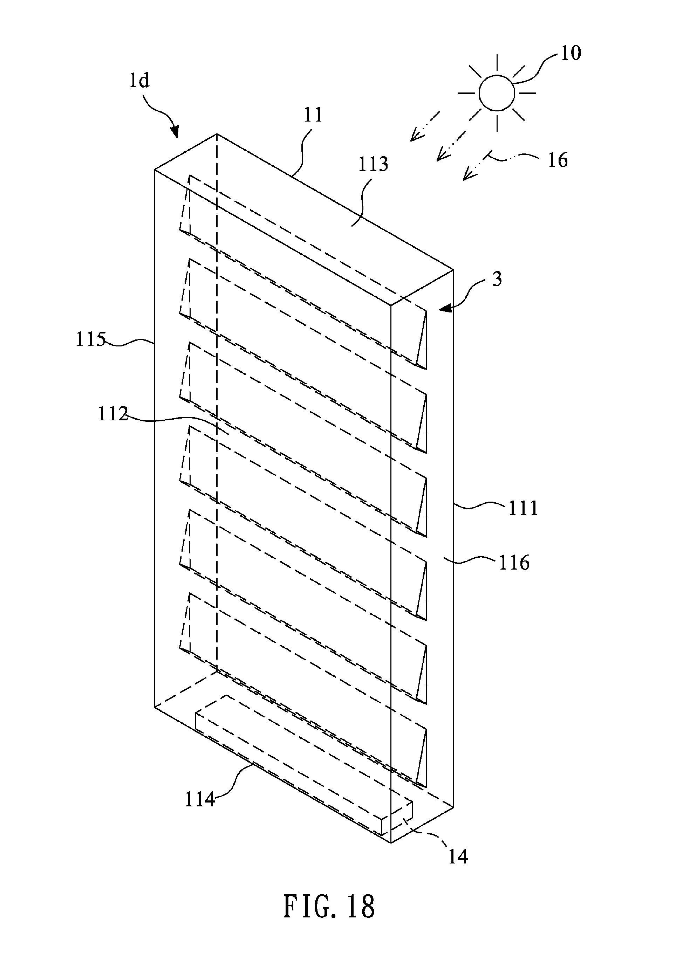

FIG. 18 shows a perspective view of a power generating module according to another embodiment of the present invention. The power generating module 1d comprises a light-guiding substrate 11 and at least one photoelectric conversion element 14. The light-guiding substrate 11 is a transparent substrate, such as glass or light transmissible plastic film. The light-guiding substrate 11 has a first surface 111, a second surface 112, a third surface 115, a fourth surface 116, a fifth surface 113, a sixth surface 114 and a plurality of microstructures 3. The first surface 111 is opposite to the second surface 112, and adjacent to the third surface 115, the fourth surface 116, the fifth surface 113 and the sixth surface 114. The fifth surface 113 (e.g., top surface) is opposite to the sixth surface 114 (e.g., bottom surface), and the third surface 115 is opposite to the fourth surface 116. In this embodiment, the first surface 111 is an incident surface that faces toward a light source 10 so as to receive the light beam 16 from the light source 10. Preferably, the light source 10 is the sun.

The microstructures 3 are disposed in the interior of the light-guiding substrate 11 (transparent substrate), and disposed between the first surface 111 and the second surface 112. In this embodiment, the microstructures 3 are not communicated or connected to each other, that is, the microstructures 3 are substantially parallel to each other and a gap is formed therebetween. The microstructures 3 pass through the light-guiding substrate 11 and have openings on the third surface 115 and the fourth surface 116 respectively.

In this embodiment, the cross section of each of the microstructures 3 is substantially triangular. However, in other embodiment, the cross section of each of the microstructures 3 may be circular, semi-circular, elliptical, fan shape, rectangular, triangular, polygonal or other shape. In addition, there is no additional material filled in the microstructures 3, that is, there is air in the microstructures 3, and the difference between the refractive index of the air and the refractive index of the light-guiding substrate 11 is greater than 0.3.

The photoelectric conversion element 14 is disposed adjacent to the light-guiding substrate 11 or disposed on the light-guiding substrate 11. Preferably, the photoelectric conversion element 14 is a solar cell. In this embodiment, the photoelectric conversion elements 14 are adhered or attached directly to the sixth surface 114, and the area of the photoelectric conversion elements 14 is equal to or slightly less than that of the sixth surface 114. However, in other embodiment, the photoelectric conversion elements 14 may be disposed on the fifth surface 113, the third surface 115 or the fourth surface 116 of the light-guiding substrate 11.

In actual operation, the size of the microstructures 3 may be reduced to the scale of micrometer; in other embodiment, the size of the microstructures 3 may be reduced to the scale of nanometer or centimeter, but the present invention is not limited thereto. When the light beam 16 (e.g., sunlight beam) illuminates the light-guiding substrate 11 through the first surface 111, the microstructures 3 guide a part of the light beam 16 to the photoelectric conversion element 14, so as to convert the energy of the part of the light beam 16 into electrical energy. Meanwhile, another part of the light beam 16 passes through the light-guiding substrate 11. Therefore, when the power generating module 1d is applied to a window set, it will not cause the sight obstruction, and the light beam 16 can pass through the power generating module 1 without influencing the indoor illumination.

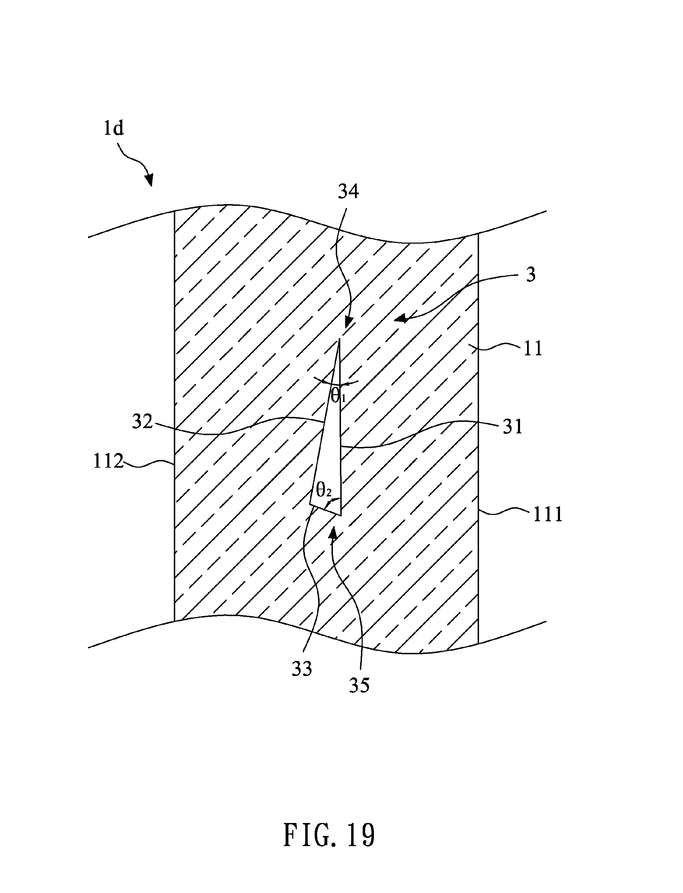

FIG. 19 shows an enlarged partially cross sectional view of the power generating module of FIG. 18. As shown in the figure, the microstructure 3 has a first side 31, a second side 32, a third side 33, a first corner 34 and a third corner 35. The first corner 34 is formed by the first side 31 and the second side 32, and the third corner 35 is formed by the first side 31 and the third side 33. The first corner 34 towards the fifth surface 113 (FIGs.1, 18), and the first side 31 of the microstructure 3 is substantially parallel to the first surface 111 of the light-guiding substrate 11. The second side 32 of the microstructure 3 is disposed between the first side 31 of the microstructure 3 and the second surface 112 of the light-guiding substrate 11. Preferably, the angle θ₁ of the first corner 34 is 5 to 30 degrees, and the angle θ₂ of the third corner 35 is 50 to 90 degrees.

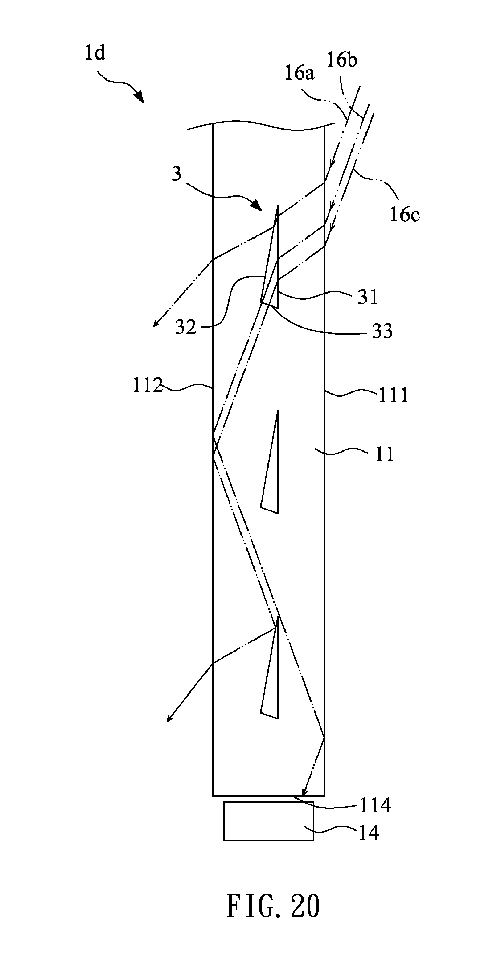

FIG. 20 shows the light paths of a part of the light beam of the power generating module of FIG. 18. In this figure, only three light beams 16a, 16b,16c are illustrated, however, it is understood that the actual light beams are not limited to these light beams 16a,16b,16c. In addition, it is to be noted that when a light beam passes through an interface, total internal reflection or refraction and reflection will occur, and the light path shown in this figure is the path of most portion of a light beam. Therefore, if most portion of a light beam refracts and less portion of the light beam reflects, only the path of refraction is shown; if most portion of a light beam reflects and less portion of the light beam refracts, only the path of reflection is shown. As shown in the figure, the light beam 16a enters the light-guiding substrate 11 through the first surface 111, then enters the microstructure 3 through the first side 31, leaves the microstructure 3 through the second side 32, and is finally emitted out from the second surface 112. The light beam 16b enters the light-guiding substrate 11 through the first surface 111, then enters the microstructure 3 through the first side 31, and leaves the microstructure 3 through the third side 33; after that, the light beam 16b is totally reflected by the second surface 112 and then totally reflected by the first surface 111, thereby arriving at the photoelectric conversion element 14. The light beam 16c enters the light-guiding substrate 11 through the first surface 111, then enters the microstructure 3 through the first side 31, and leaves the microstructure 3 through the third side 33; after that, the light beam 16c is totally reflected by the second side of the microstructure below, and is finally emitted out from the second surface 112.

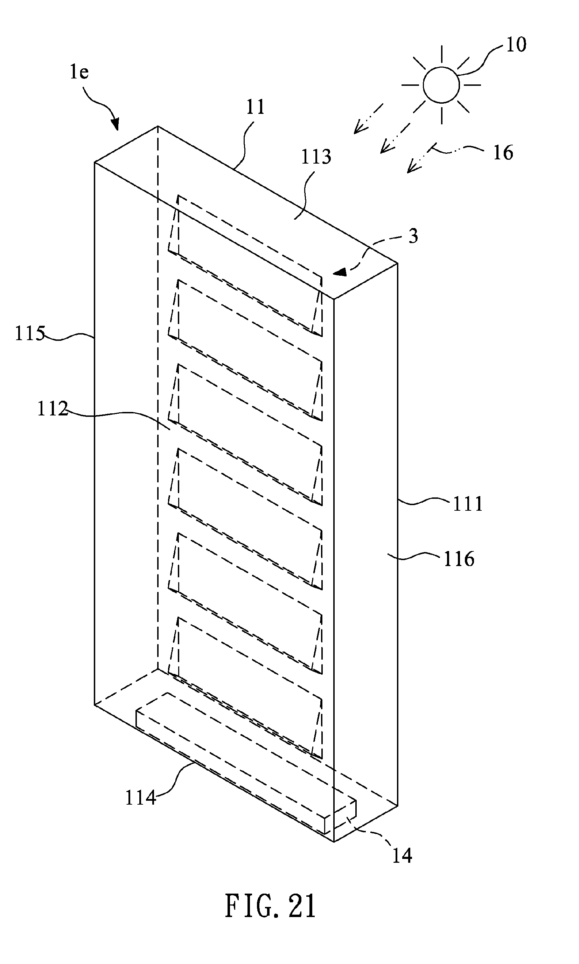

FIG. 21 shows a perspective view a power generating module according to another embodiment of the present invention. The power generating module 1e in this embodiment is generally the same as the power generating module 1d shown in FIG. 18. The difference lies in that, in this embodiment, the microstructures 3 of the power generating module 1e do not penetrate the light-guiding substrate 11, but are near the third surface 115 or the fourth surface 116 of the light-guiding substrate 11.

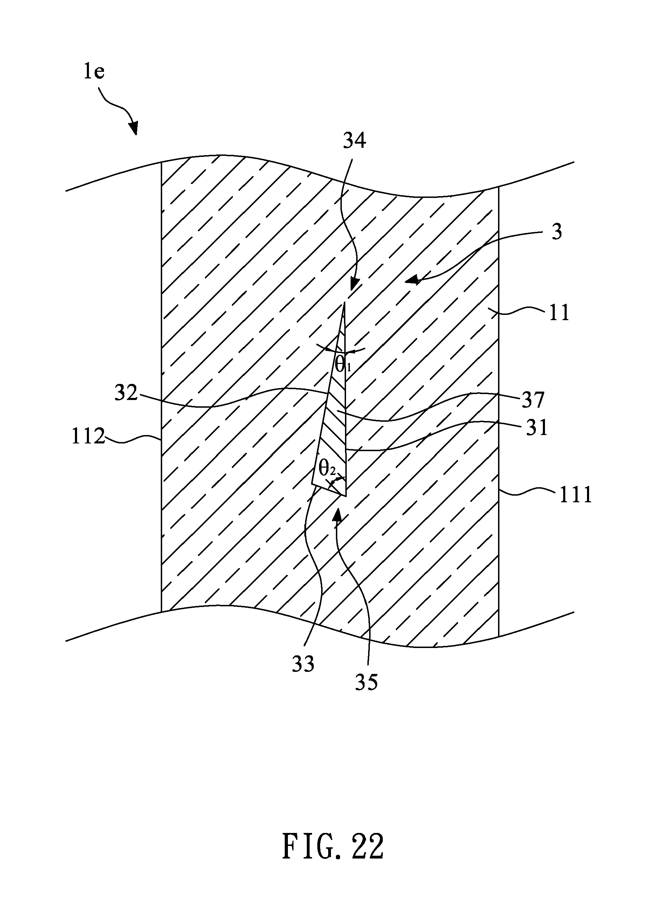

FIG. 22 shows a cross sectional view of a power generating module according to another embodiment of the present invention. The power generating module 1e is generally the same as the power generating module 1d shown in FIG. 18 and FIG. 19. The difference lies in that, in this embodiment, the power generating module 1e further includes an internal element 37 located in a space defined by the microstructure 3, where the difference between the refractive index of the internal element 37 and the refractive index of the light-guiding substrate 11 is greater than 0.3. The material of the internal element 37 may be liquid (for example, water and oil), gel (for example, silicone and epoxy), glass, metal or plastic.

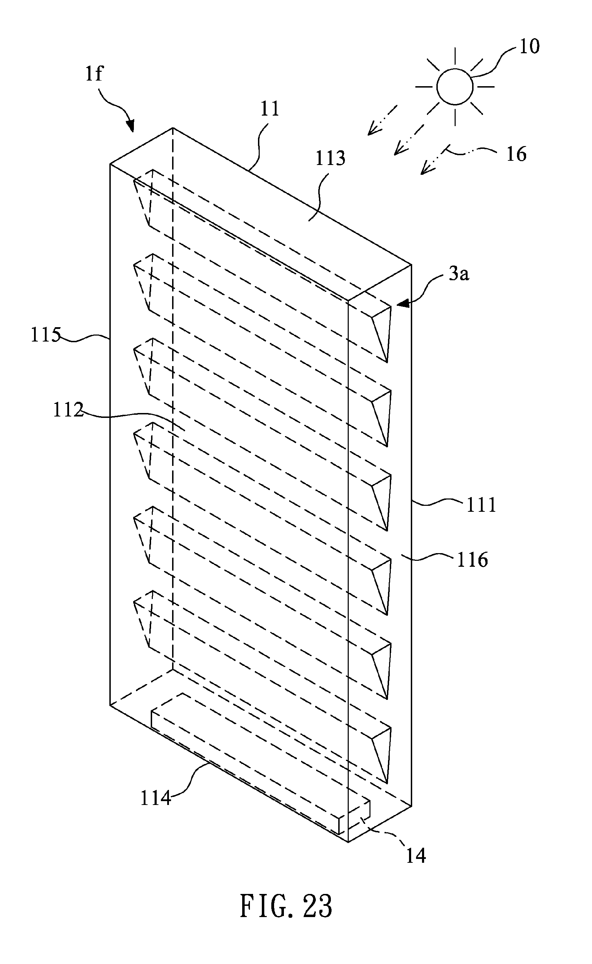

FIG. 23 shows a perspective view of a power generating module according to another embodiment of the present invention. The power generating module 1f of this embodiment is generally the same as the power generating module 1d shown in FIG. 18. The difference lies in that, in this embodiment, the microstructures 3a of the power generating module 1f are in a shape of inverted triangle.

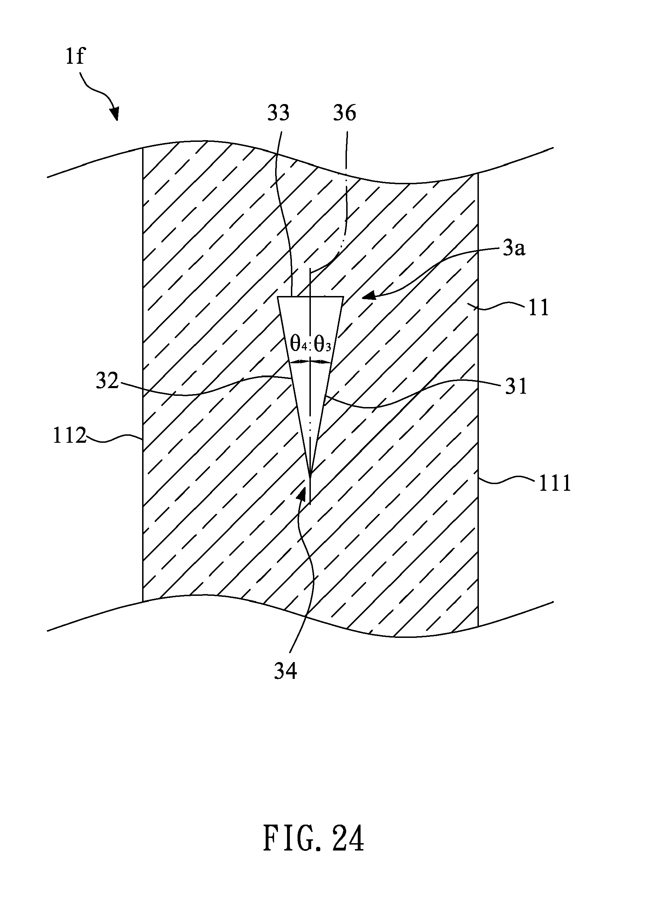

FIG. 24 shows an enlarged partially cross sectional view of the power generating module in FIG. 23. As shown in this figure, the microstructure 3a has a first side 31, a second side 32, a third side 33, and a first corner 34. The first side 31 and the second side 32 form the first corner 34. The first corner 34 is toward the sixth surface 114 (FIG. 23), and the third side 33 is substantially parallel to the fifth surface 113 (FIG. 23). Preferably, the microstructure 3a further includes an imaginary plane 36, which is parallel to the first surface 111, and divides the first corner 34 into a first included angle θ₃ and a second included angle θ₄; the first side 31 and the imaginary plane 36 form the first included angle θ₃; the second side 32 and the imaginary plane 36 form the second included angle θ₄; the first included angle θ₃ is 0 to 20 degrees, and the second included angle θ₄ is 0 to 20 degrees. The first included angle θ₃ is equal to or not equal to the second included angle θ₄, while the first included angle θ₃ and the second included angle θ₄ will not be 0 at the same time.

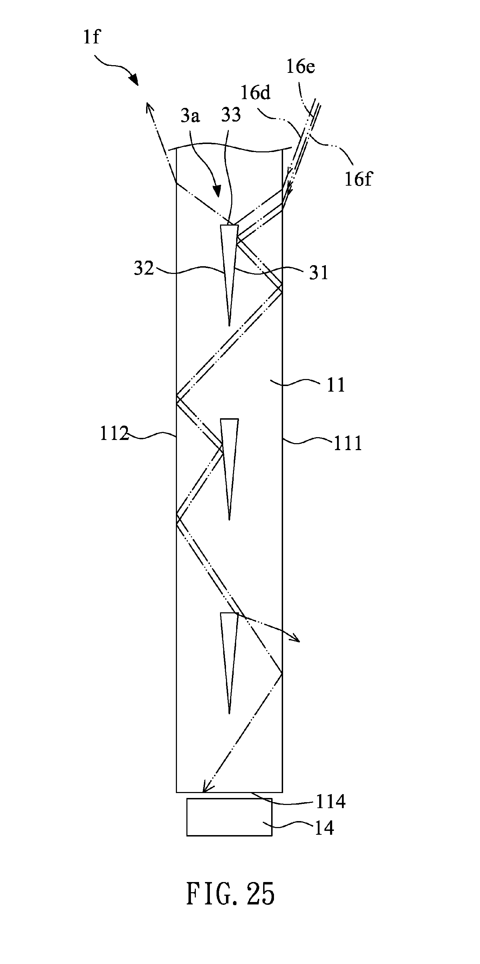

FIG. 25 shows the light paths of a part of the power generating module in FIG. 23. In this figure, only three light beams 16a, 16b, and 16c are illustrated, however, it is understood that the actual light beams are not limited to these light beams 16a, 16b, and 16c. In addition, it is to be noted that when a light beam passes through an interface, total reflection or refraction and reflection will occur, and the light path shown in this figure is the path of most portion of a light beam. Therefore, if most portion of a light beam refracts and less portion of the light beam reflects, only the path of refraction is shown; if most portion of a light beam reflects and less portion of the light beam refracts, only the path of reflection is shown. As shown in the figure, the light beam 16d enters the light-guiding substrate 11 through the first surface 111, then is totally reflected by the third side 33, and is finally emitted out from the second surface 112. The light beam 16e enters the light-guiding substrate 11 through the first surface 111, then is totally reflected by the first side 31, totally reflected by the first surface 111, totally reflected by the second surface 112, totally reflected by the second side of the microstructure below, totally reflected by the second surface 112, and finally totally reflected by the first surface 111, thereby arriving at the photoelectric conversion element 14. The light beam 16f enters the light-guiding substrate 11 through the first surface 111, then is totally reflected by the first side 31, totally reflected by the first surface 111, totally reflected by the second surface 112, totally reflected by the second side of the microstructure below, totally reflected by the second surface 112, then enters the microstructure below through the third side of the microstructure below, leaves the microstructure below through the first side, and is finally emitted out from the first surface 111.

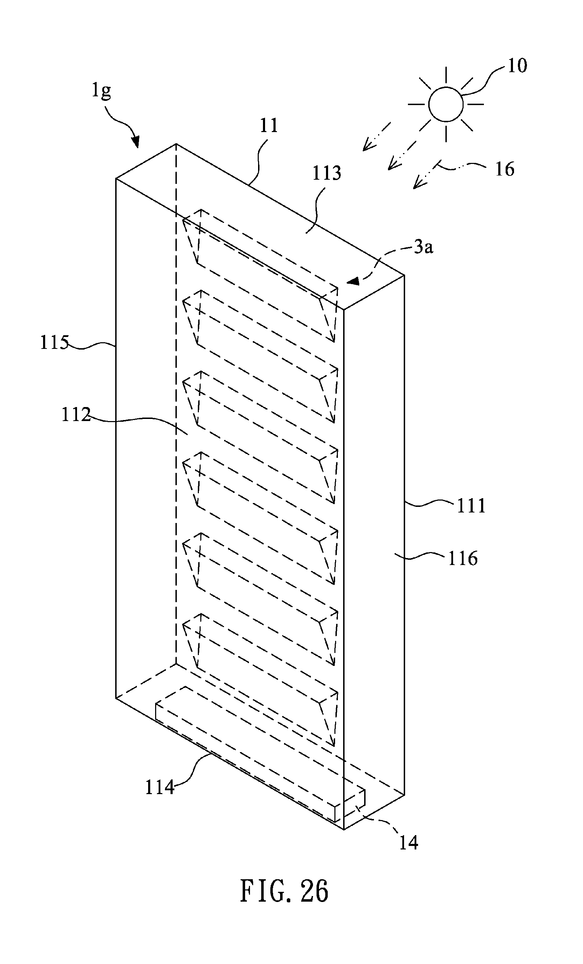

FIG. 26 shows a perspective view of a power generating module according to another embodiment of the present invention. The power generating module 1g of this embodiment is generally the same as the power generating module 1f shown in FIG. 23. The difference lies in that, in this embodiment, the microstructures 3a of the power generating module 1g do not penetrate through the light-guiding substrate 11, but are near the third surface 115 or the fourth surface 116 of the light-guiding substrate 11.

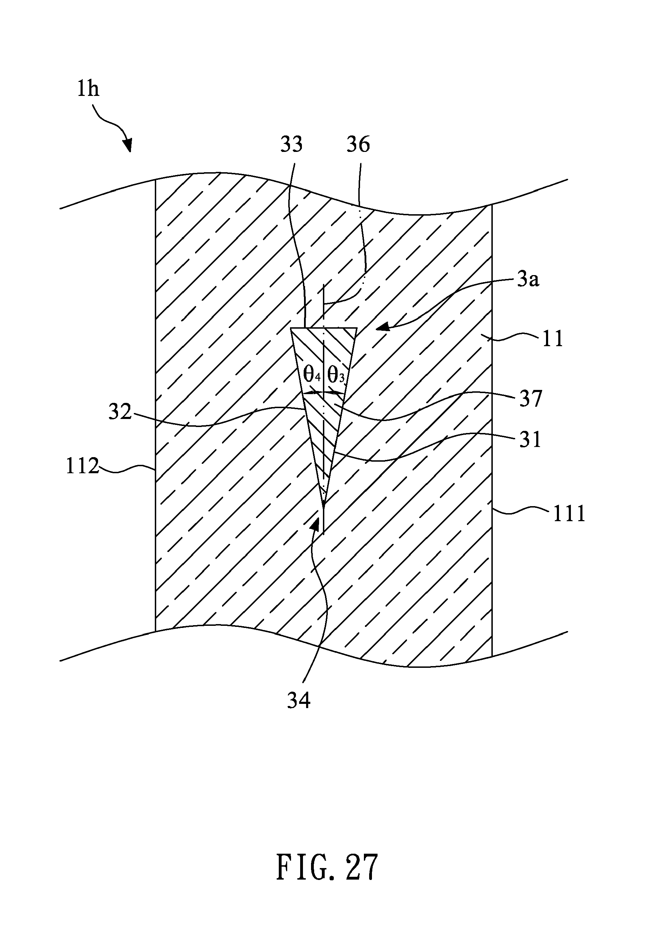

FIG. 27 shows a cross sectional view of a power generating module according to another embodiment of the present invention. The power generating module 1h of this embodiment is generally the same as the power generating module 1f shown in FIG. 23 and FIG. 24. The difference lies in that, in this embodiment, the power generating module 1h further includes an internal element 37 located in a space defined by the microstructure 3a, where the difference between the refractive index of the internal element 37 and the refractive index of the light-guiding substrate 11 is greater than 0.3. The material of the internal element 37 may be liquid, gel, glass, metal or plastic.

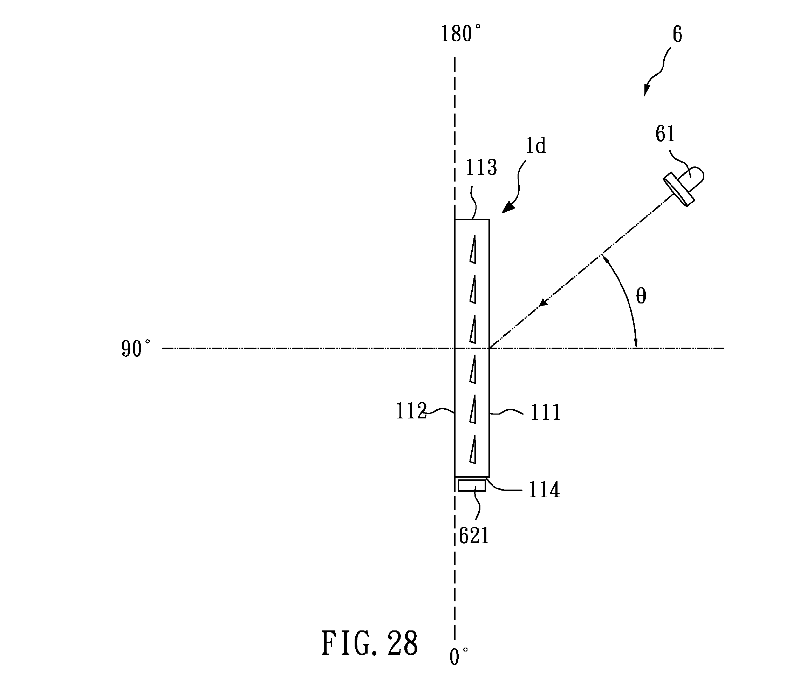

FIG. 28 shows a schematic view of an application of simulating the power generating module of the present invention by utilizing a test instrument. A test instrument 6 includes at least one light source 61 and a receiver 621. The power generating module 1d (FIG. 18 and FIG. 19) are located at the center of the test instrument 6, the light source 61 is located at the right side of the light-guiding substrate 11, and the receiver 621 is located under the light-guiding substrate 11.

The light source 61 is used for generating an incident light beam with an incident angle being θ degrees, where θ is 10 to 80. The simulation parameters are described as follows. The refractive index of the light-guiding substrate 11 is 1.51; the size thereof is 240 millimeter (mm)*180 millimeter (mm), with a thickness of 6 mm. The area that the light source 61 projects on the light-guiding substrate 11 is 216 millimeter (mm)*162 millimeter (mm). The size of the receiver 621 is 240 millimeter (mm)*6 millimeter (mm). The distance between the light source 61 and the light-guiding substrate 11 is 1000 millimeter (mm). The distance between receiver 621 and the light-guiding substrate 11 is 0.1 millimeter (mm).

This simulation measures the light-guiding substrates 11 of three different patterns, as described below. The first pattern is the light-guiding substrate 11 of the power generating module 1d in FIG. 18 and FIG. 19, where the angle θ₁ of the first corner 34 is 10 degrees, and the angle θ₂ of the third corner 35 is 70 degrees. The second pattern is the light-guiding substrate 11 of the power generating module 1f of FIG. 23 and FIG. 24, where the first included angle θ₃ is 5 degrees, and the second included angle θ₄ is 5 degrees. The third pattern is the light-guiding substrate 11 of the power generating module 1f of FIG. 23 and FIG. 24, where the first included angle θ₃ is 10 degrees, and the second included angle θ₄ is 0 degree.

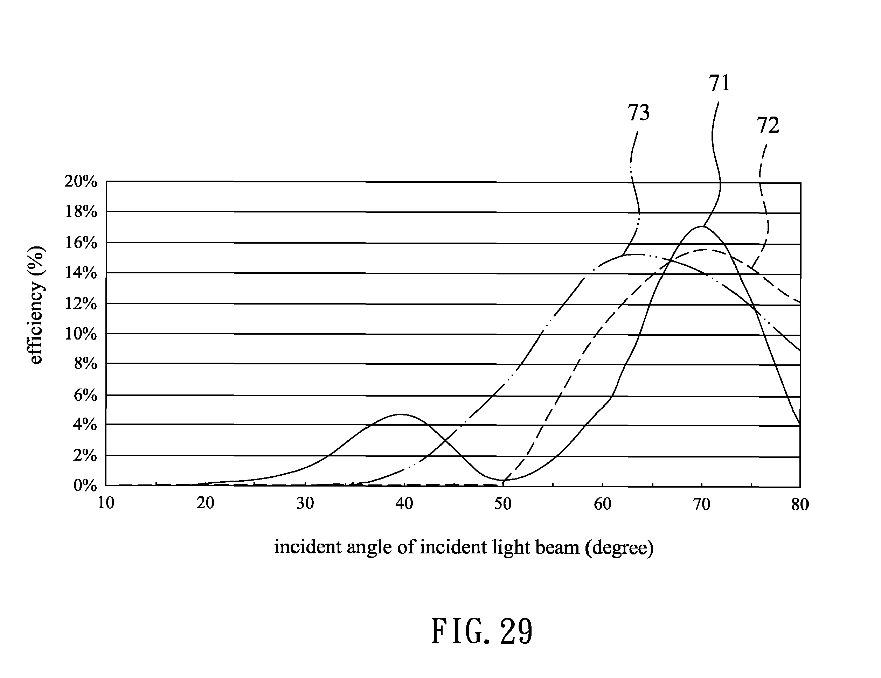

FIG. 29 shows simulation results of light-guiding substrates with different patterns by using the test instrument as shown in FIG. 28, wherein a curve 71 represents the light-guiding substrate of the first pattern, a curve 72 represents the light-guiding substrate of the second pattern, and a curve 73 represents the light-guiding substrate of the third pattern. In the figure, the abscissa is the incident angle θ of the incident light beam emitted by the light source 61, and the efficiency of the ordinate (%) is defined as the luminous flux measured by the receiver 621 divided by the luminous flux of the incident light beam emitted by the light source 61, namely, a ratio of the luminous flux of the receiver 621 to the total luminous flux of the incident light beam.

The simulation results are shown in Table 1 below. The first pattern, second pattern and third pattern are sequentially arranged from left to right in Table 1.

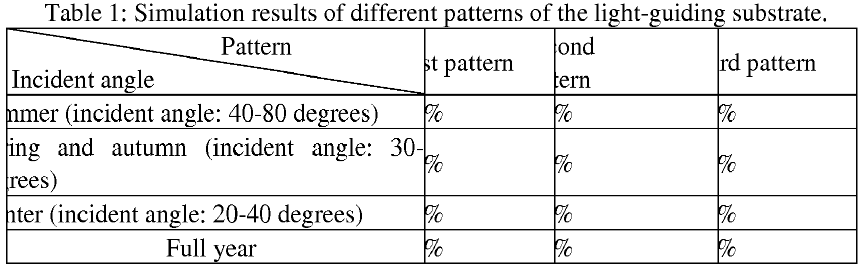

In Table 1, taking the first pattern at the left side as an example, the incident angle of 40-80 degrees is an average sunlight incident angle from eight o'clock in the morning to four o'clock in the afternoon during summer in Taiwan. The simulation result indicates that at this incident angle, about 6.3% of the incident light will be guided to the sixth surface 114 (namely, the position of the photoelectric conversion element 14) of the light-guiding substrate 11. Similarly, the incident angle of 30-70 degrees is an average sunlight incident angle from eight o'clock in the morning to four o'clock in the afternoon during spring in Taiwan. The simulation result indicates that at this incident angle, about 5.7% of the incident light will be guided to the sixth surface 114 (namely, the position of the photoelectric conversion element 14) of the light-guiding substrate 11.

Therefore, the light-guiding substrate 11 not only reserves the light transmitting function, but also achieves the solar power generating function. In addition, FIG. 29 and Table 1 indicate that the light-guiding substrate 11 with different microstructure patterns will have different optical properties under different incident angles. Therefore, users may select a light-guiding substrate 11 with a desired microstructure pattern according to the actual sunlight incident angle.

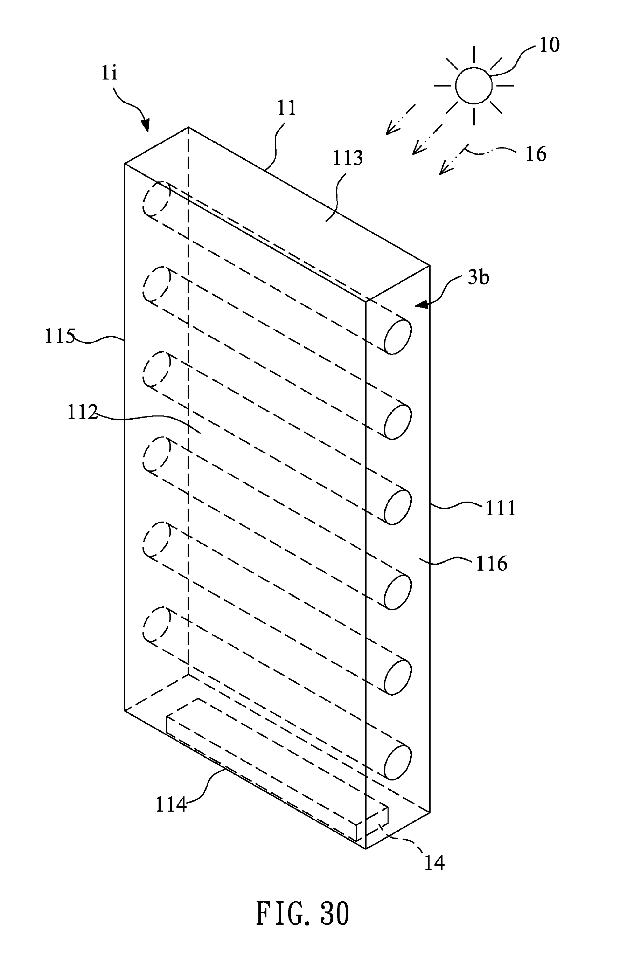

FIG. 30 shows a perspective view of a power generating module according to another embodiment of the present invention. The power generating module 1i of this embodiment is generally the same as power generating module 1d shown in FIG. 18. The difference lies in that, in this embodiment, the microstructures 3b of the power generating module 1i are cylindrical.

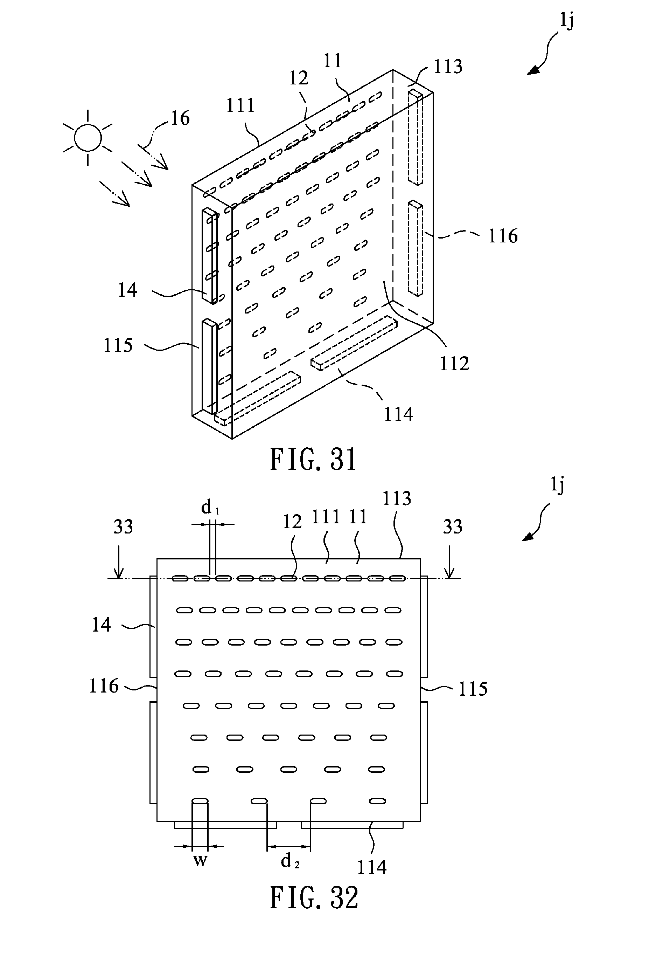

FIG. 31 and FIG. 32 respectively show a perspective view and a front view of a power generating module according to another embodiment of the present invention. The power generating module 1j of this embodiment is generally the same as the power generating module 1 shown in FIG. 1 and FIG. 2. The difference lies in that, in this embodiment, the microstructures 12 of the power generating module 1j each have an opening width W, and the opening widths W are the same. In addition, the light-guiding substrate 11 has a first surface 111, a second surface 112, a first end 114 (namely, the sixth surface 114), a second end 113 (namely, the fifth surface 113), a third end 115 (namely, the third surface 115), and a fourth end 116 (namely, the fourth surface 116). In this embodiment, an interval d₁ between the microstructures 12 near the second end 113 is smaller than an interval d₂ between the microstructures 12 near the first end 114. That is, the density of the microstructures 12 is gradually increased from the portion near the first end 114 to the portion near the second end 113. The brightness of the light beam guided to the photoelectric conversion element 14 can be adjusted by using the design of different density of the microstructures 12.

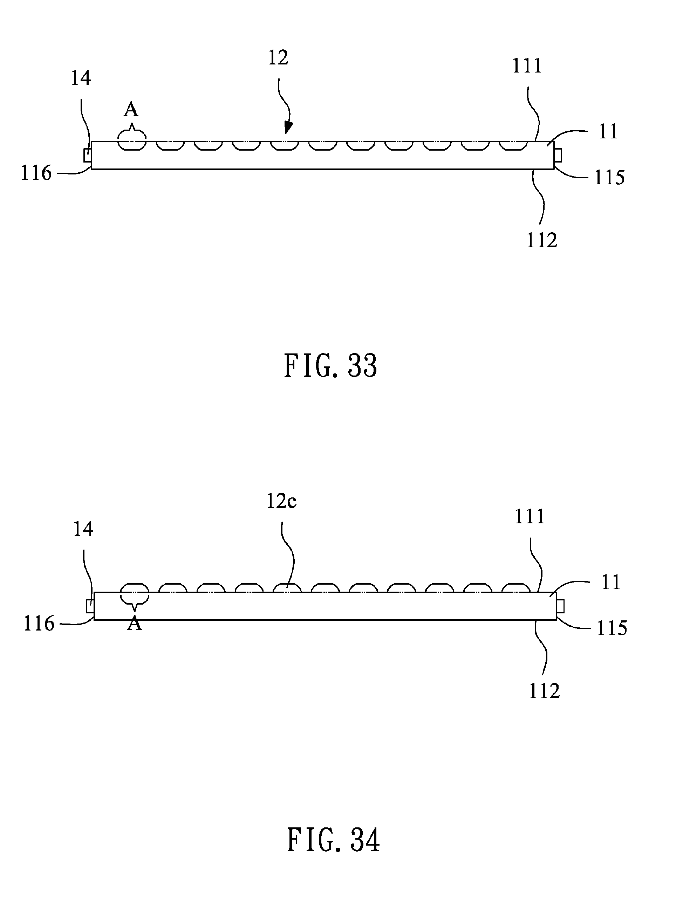

FIG. 33 shows a cross sectional view taken along line 33-33 of FIG. 32. As shown in this figure, each of the recessed microstructures 12 has a curved profile, where each of the microstructures 12 projects on the first surface 111, forming a projection area A. In this embodiment, the sum of the projection areas A of the microstructures 12 is 15% to 50% of the entire surface area of the first surface 111, that is, the density of the microstructures 12 is defined as a ratio between the sum of the projection areas A of the microstructures 12 and the surface area of the first surface 111. In this embodiment, the sum of the projection areas A of the microstructures 12 is 15% to 50%, and preferably 20% to 40%, of the surface area of the first surface 111.

FIG. 34 shows another pattern of the microstructure of FIG. 33. As shown in this figure, the microstructures 12c protrude from the first surface 111. Similarly, each of the microstructures 12c projects on the first surface 111, forming a projection area A.

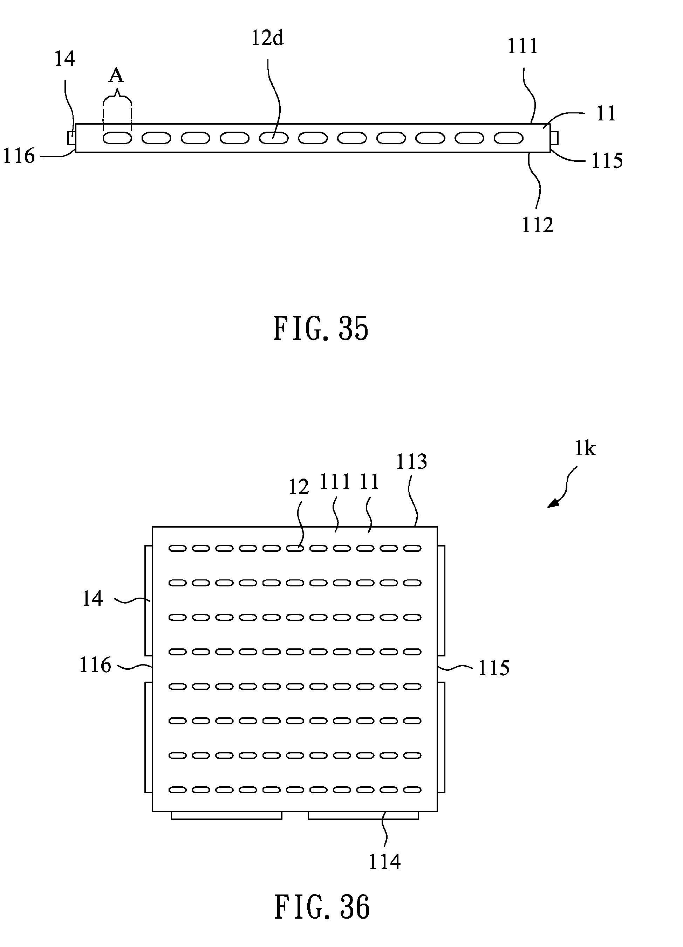

FIG. 35 shows another pattern of the microstructure of FIG. 33. As shown in this figure, the microstructures 12d are disposed in the interior of the light-guiding substrate 11, and are not communicated to the first surface 111 or the second surface 112. Similarly, each of the microstructures 12d projects on the first surface 111, forming a projection area A.

FIG. 36 shows a front view of a power generating module according to another embodiment of the present invention. The power generating module 1k of this embodiment is generally the same as the power generating module 1j shown in FIG 32. The difference lies in that, in this embodiment, the intervals between the microstructures 12 are equal.

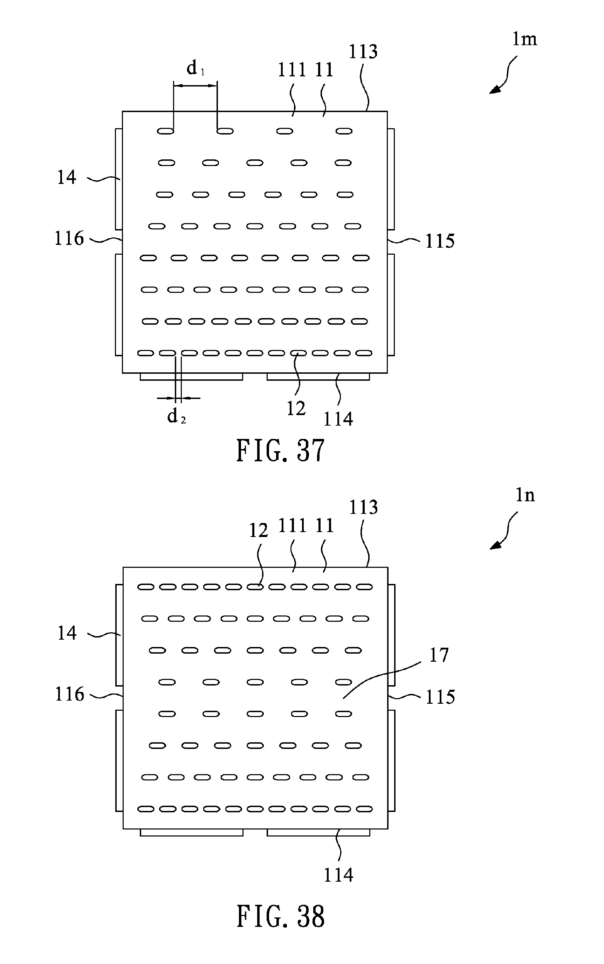

FIG. 37 shows a front view of a power generating module according to another embodiment of the present invention. The power generating module 1m of this embodiment is generally the same as the power generating module 1j shown in FIG 32. The difference lies in that, in this embodiment, the interval d₁ between the microstructures 12 near the second end 113 is greater than the interval d₂ between the microstructures 12 near the first end 114. That is, the density of the microstructures 12 is gradually decreased from the portion near the first end 114 to the portion near the second end 113.

FIG. 38 shows a front view of a power generating module according to another embodiment of the present invention. The power generating module 1n of this embodiment is generally the same as the power generating module 1j shown in FIG 32. The difference lies in that, in this embodiment, the light-guiding substrate 11 further has a central portion 17 located between the first end 114 and the second end 113. The density of the microstructures 12 near the first end 114 is equal to the density of the microstructures near the second end 113, and is greater than the density of the microstructures 12 at the central portion 17.

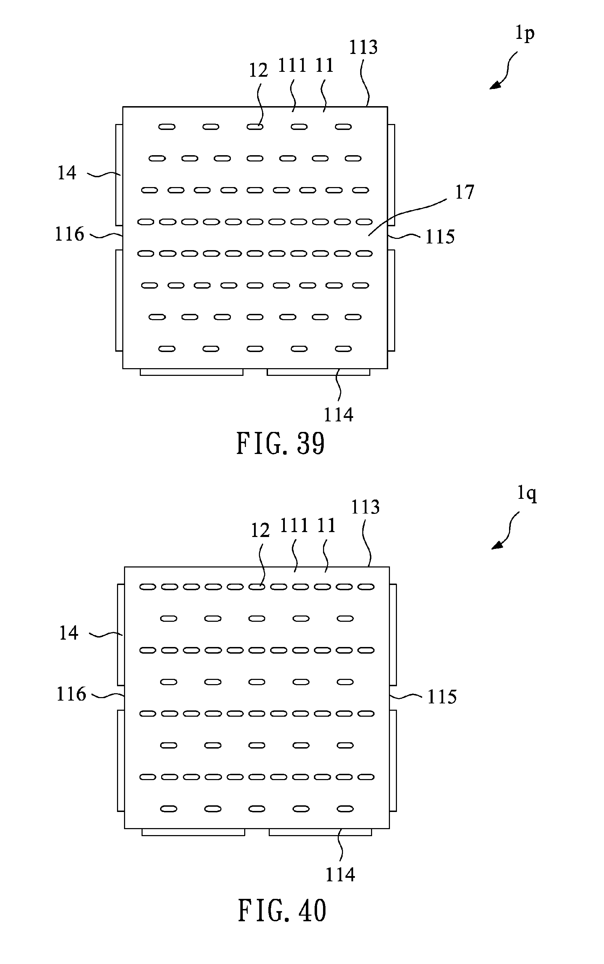

FIG. 39 shows a front view of a power generating module according to another embodiment of the present invention. The power generating module 1p of this embodiment is generally the same as the power generating module 1j shown in FIG 32. The difference lies in that, in this embodiment, the light-guiding substrate 11 further has a central portion 17 located between the first end 114 and the second end 113. The density of the microstructures 12 near the first end 114 is equal to the density of the microstructures near the second end 113, and is smaller than the density of the microstructures 12 at the central portion 17.

FIG. 40 shows a front view of a power generating module according to another embodiment of the present invention. The power generating module 1q of this embodiment is generally the same as the power generating module 1j shown in FIG 32. The difference lies in that, in this embodiment, the microstructures 12 are distributed alternatingly with high density and low density from the portion near the first end 114 to the portion near the second end 113.

The shape, size, interval or density of the microstructures 12 of the present invention are not limited to those described herein, and different shapes, sizes, intervals and/or density of the microstructures can be used in coordination. For example, the first surface 111 has microstructures of many shapes; or, for example, the first surface 111 has microstructures of different shapes and sizes in coordination.

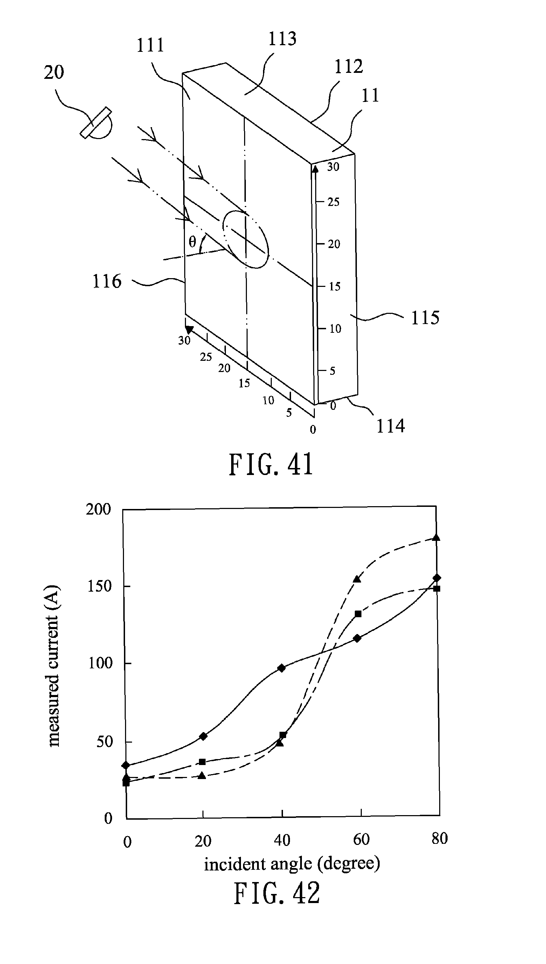

FIG. 41 shows a schematic view of another testing environment of a power generating module of the present invention. The testing environment of this embodiment is generally the same as the testing environment in FIG. 12. The difference lies in that, in the testing environment of this embodiment, the light source 20 illuminates the first surface 111 of the light-guiding substrate 11, and sensors are disposed on the first end 114, the third end 115, and the fourth end 116 of the light-guiding substrate 11 for measurement.

FIG. 42 shows a diagram of test results of the light-guiding substrate in FIG. 36 under different microstructure density, wherein ◆ represents the current values measured by the sensors when a light-guiding substrate with the microstructure density being 78% is illuminated by the incident light with different incident angles; ■ represents the current values measured by the sensors when a light-guiding substrate with the microstructure density being 39% is illuminated by the incident light with different incident angles; and ▲ represents the current values measured by the sensors when a light-guiding substrate with the microstructure density being 19.5% is illuminated by the incident light with different incident angles. The figure shows that even if the microstructure density is as small as 19.5%, a great current value is measured by the sensors in the case of a high incident angle, which indicates that greater microstructure density is not necessarily better.

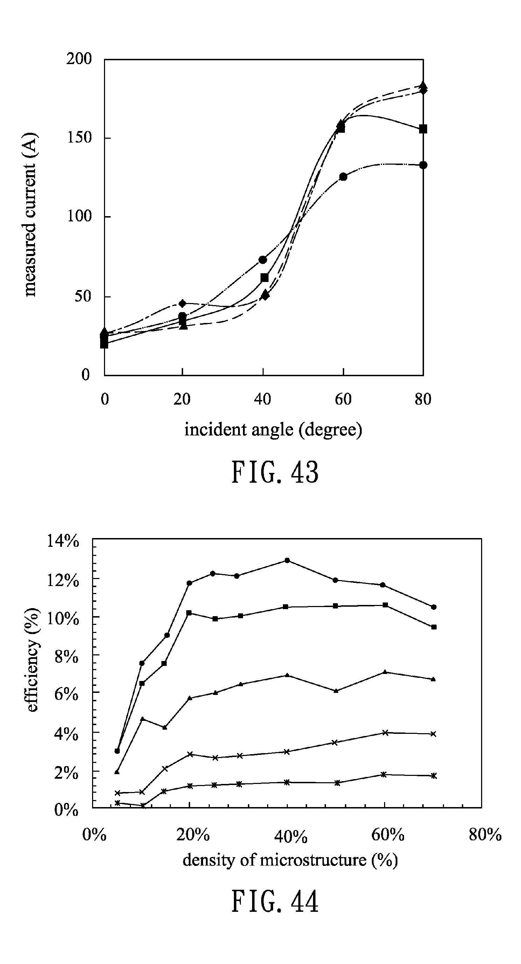

FIG. 43 shows a diagram of test results of light-guiding substrates with the microstructure density still being 19.5% but having different microstructure distribution patterns, wherein ▲ represents current values measured by the sensors when a light-guiding substrate 11 with evenly distributed microstructures (FIG. 36) is illuminated by the incident light with different incident angles (this curve is the same as that in FIG. 42); ◆ represents current values measured by the sensors when a light-guiding substrate 11 with a microstructure distribution pattern shown in FIG. 32 (the density of the microstructures 12 is gradually increased from the portion near the first end 114 to the portion near the second end 113) is illuminated by the incident light with different incident angles; ■ represents current values measured by the sensors when a light-guiding substrate 11 with a microstructure distribution pattern shown in FIG. 39 (the density of the microstructures 12 near the first end 114 is equal to the density of the microstructures near the second end 113, and is smaller than the density of the microstructures 12 at the central portion 17) is illuminated by the incident light with different incident angles; and • represents current values measured by the sensors when a light-guiding substrate 11 with a microstructure distribution pattern shown in FIG. 38 (the density of the microstructures 12 near the first end 114 is equal to the density of the microstructures near the second end 113, and is greater than the density of the microstructures 12 at the central portion 17) is illuminated by the incident light with different incident angles. As shown in FIG. 42, even if the microstructure density is as small as 19.5%, the current values of the light-guiding substrates with different microstructure distribution patterns measured by the sensors are not significantly different, which indicates that the microstructure distribution pattern has a small impact on the light guiding efficiency of the light-guiding substrate 11.

FIG. 44 shows a diagram of optical simulation results when light-guiding substrates with different microstructure density are illuminated by incident light with different incident angles, wherein • represents that the incident angle θ of the incident light is 80 degrees; ■ represents that the incident angle θ of the incident light is 70 degrees; ▲ represents that the incident angle θ of the incident light is 60 degrees; × represents that the incident angle θ of the incident light is 50 degrees; and * represents that the incident angle θ of the incident light is 40 degrees. In addition, the light guiding efficiency of the ordinate represents a ratio of the incident light energy to the energy measured by the sensors. This figure shows that the microstructure density influences the light guiding efficiency, and desirable light guiding efficiency is achieved when the microstructure density is 15% and 50% (preferably, 20% to 40%), especially in the case of a high incident angle (for example, 70 degrees or 80 degrees).

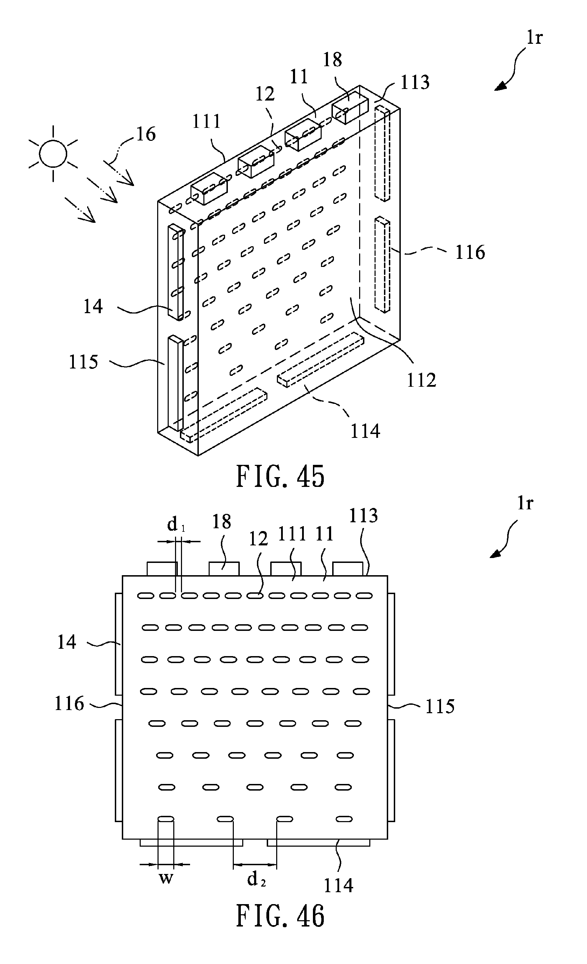

FIG. 45 and FIG. 46 respectively show a perspective view and a front view of a power generating module according to another embodiment of the present invention. The power generating module 1r of this embodiment is generally the same as the power generating module 1j shown in FIG. 31 and FIG. 32. The difference lies in that, in this embodiment, the power generating module 1r further includes at least one illumination element 18. The illumination element 18 is disposed adjacent to the fifth surface 113 of the light-guiding substrate 11. Preferably, the illumination element 18 is a solid light source, for example, a light emitting diode (LED). In this embodiment, the illumination element 18 is directly adhered to the fifth surface 113.

The photoelectric conversion element 14 is disposed adjacent to the sixth surface 114 of the light-guiding substrate 11. Preferably, the photoelectric conversion element 14 is directly adhered to the sixth surface 114, the third surface 115, and the fourth surface 116.

In actual use, when the light beam 16 (for example, sunlight) illuminates the first surface 111, and the microstructures 12 guides a part of the light beam 16 to the photoelectric conversion element 14, so as to convert the energy of the part of the light beam 16 into electrical energy. Meanwhile, another part of the light beam 16 directly passes through the light-guiding substrate 11.

In addition, when the light beam 16 is unavailable (for example, during the night), the illumination element 18 can be turned on so as to emit a light beam (not shown in the figure) to the light-guiding substrate 11 through the fifth surface 113. At this time, the microstructures 12 guide a part of the light beam to the second surface 112 of the light-guiding substrate 11 to emit out, so that the second surface 112 becomes a light emitting surface. In this case, it is understood that a part of the light beam may also be emitted out through the first surface 111 of the light-guiding substrate 11; or the microstructures 12 may also guide a part of the light beam to the photoelectric conversion element 14 of the light-guiding substrate 11, so as to convert the energy thereof into electrical energy. Therefore, the power generating module 1r not only has a power generating function but also has an illumination function.

In addition, it is understood that the power generating module 1j of FIG. 31 and FIG. 32, the power generating module 1k of FIG. 36, the power generating module 1m of FIG. 37, the power generating module 1n of FIG. 38, the power generating module 1p of FIG. 39, and the power generating module 1q of FIG. 40 may further include the illumination element 18 disposed on the fifth surface 113 of the light-guiding substrate 11.

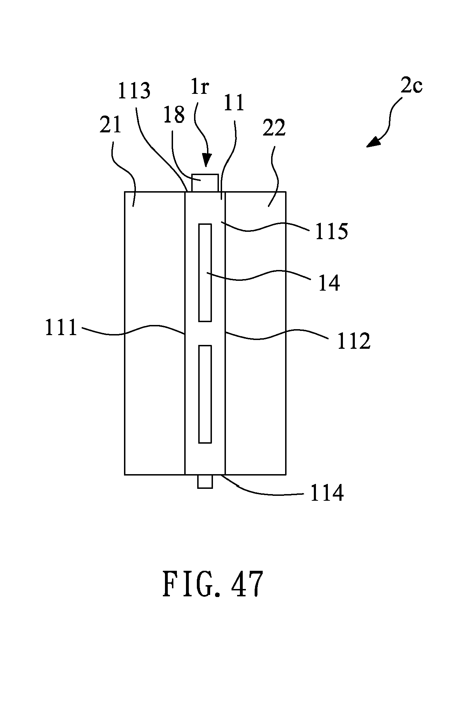

FIG. 47 shows a side view of a power generating window set according to another embodiment of the present invention. The power generating window set 2c of this embodiment is generally the same as the power generating window set 2 shown in FIG. 15. The difference lies in that, in this embodiment, the power generating window set 2c includes the power generating module 1r.

While several embodiments of the present invention have been illustrated and described, various modifications and improvements can be made by those skilled in the art. The embodiments of the present invention are therefore described in an illustrative but not restrictive sense. It is intended that the present invention should not be limited to the particular forms as illustrated, and that all modifications which maintain the spirit and scope of the present invention are within the scope defined in the appended claims.

## Claims

1. A power generating module comprising:
a light-guiding substrate, having a first surface, a second surface and a plurality of microstructures, wherein the first surface is adjacent to or opposite to the second surface; and
at least one photoelectric conversion element, disposed adjacent to the light-guiding substrate, when a light beam illuminates the light-guiding substrate, the microstructures guide a part of the light beam to the at least one photoelectric conversion element, so as to convert the energy of the part of the light beam into electrical energy.

2. The power generating module as claimed in Claim 1, wherein the microstructures are recessed in the light-guiding substrate from the first surface, when the light beam arrives at the first surface, the microstructures guide a part of the light beam to the at least one photoelectric conversion element, so as to convert the energy of the part of the light beam into electrical energy.

3. The power generating module as claimed in Claim 2, wherein the light beam passes through the second surface before arriving at the first surface.

4. The power generating module as claimed in Claim 2 or 3, wherein each of the microstructures has an opening width on the first surface, and the opening widths are not even.

5. The power generating module as claimed in any of the preceding claims, wherein each of the microstructures is in elliptical shape from top view.

6. The power generating module as claimed in any of the preceding claims, wherein the microstructures are not connected to each other.

7. The power generating module as claimed in any of the preceding claims, wherein the light beam is sunlight beam, and the photoelectric conversion element is a solar cell.

8. The power generating module as claimed in any of the preceding claims, wherein the light-guiding substrate is a transparent substrate, and the microstructures are disposed in the interior of the transparent substrate.

9. The power generating module as claimed in Claim 8, wherein the microstructures are substantially parallel to each other.

10. The power generating module as claimed in Claim 8 or 9, wherein the light-guiding substrate further has a third surface adjacent to the first surface and the second surface, and wherein
at least one of the microstructures passes through the third surface of the light-guiding substrate.

11. The power generating module as claimed in Claim 8, wherein the light-guiding substrate further has a third surface adjacent to the first surface and the second surface, and at least one of the microstructures is disposed adjacent to the third surface of the light-guiding substrate.

12. The power generating module as claimed in any of the preceding claims, further comprising an internal element disposed in a space defined by at least one of the microstructures, wherein a difference between a refractive index of the internal element and a refractive index of the light-guiding substrate is greater than 0.3, wherein the material of the light-guiding substrate is glass or plastic, and the material of the internal element is air, water, oil, silicone, epoxy, glass, metal or plastic.

13. The power generating module as claimed in any of claims 8 to 12, wherein the light-guiding substrate further has a third surface, a fourth surface, a fifth surface and a sixth surface, wherein the third surface is adjacent to the first surface and the second surface, the fourth surface is opposite to the third surface, the fifth surface is adjacent to the first surface, the second surface and the third surface, the sixth surface is opposite to the fifth surface, the microstructures are disposed between the first surface and the second surface, a cross section of each of the microstructures is substantially triangular, and the at least one photoelectric conversion element includes a plurality of photoelectric conversion elements disposed adjacent to the fourth surface, the fifth surface and the sixth surface.

14. The power generating module as claimed in Claim 13, wherein each of the microstructures has a first side, a second side and a first corner, the first corner is formed by the first side and the second side and toward the fifth surface, the first side of the microstructure is substantially parallel to the first surface of the light-guiding substrate, and the second side of the microstructure is disposed between the first side of the microstructure and the second surface of the light-guiding substrate.

15. The power generating module as claimed in Claim 14, wherein each of the microstructures further has a third side and a third corner, the third corner is formed by the first side and the third side, an angle of the third corner is 50 to 90 degrees, and an angle of the first corner is 5 to 30 degrees.

16. The power generating module as claimed in any of claims 13 to 15, wherein each of the microstructures has a first side, a second side, a third side and a first corner, the first corner is formed by the first side and the second side and toward the sixth surface, the third side of the microstructure is substantially parallel to the fifth surface of the light-guiding substrate.

17. The power generating module as claimed in Claim 16, further comprising a reference plane parallel to the first surface and dividing the first corner into a first corner portion and a second corner portion, the first corner portion is formed by the first side and the reference plane, the second corner portion is formed by the second side and the reference plane, wherein an angle of the first corner portion is 0 to 20 degrees, and an angle of the second corner portion is 0 to 20 degrees.

18. The power generating module as claimed in any of the preceding claims, wherein the sum of the areas that the microstructures project on the first surface is 15% to 50% of the entire surface area of the first surface.

19. The power generating module as claimed in any of the preceding claims, wherein the light-guiding substrate further has a first end and a second end adjacent to the first surface, the first end is opposite to the second end, wherein the density of the microstructures is gradually increased from the portion near the first end to the portion near the second end.

20. The power generating module as claimed in any of claims 1 to 16, wherein the light-guiding substrate further has a first end and a second end adjacent to the first surface, the first end is opposite to the second end, wherein the microstructures are distributed alternatingly with high density and low density from the portion near the first end to the portion near the second end.

21. The power generating module as claimed in any of claims 1 to 16, wherein the light-guiding substrate further has a first end, a second end and a central portion adjacent to the first surface, the first end is opposite to the second end, the central portion is disposed between the first end and the second end, wherein the density of the microstructures near the first end is higher than that of the microstructures at the central portion, and the density of the microstructures near the second end is higher than that of the microstructures at the central portion.

22. The power generating module as claimed in any of claims 1 to 16, wherein the light-guiding substrate further has a first end, a second end and a central portion adjacent to the first surface, the first end is opposite to the second end, the central portion is disposed between the first end and the second end, wherein the density of the microstructures near the first end is lower than that of the microstructures at the central portion, and the density of the microstructures near the second end is lower than that of the microstructures at the central portion.

23. The power generating module as claimed in Claim 13, wherein the microstructures guide a part of the light beam that arrives at the first surface to the at least one photoelectric conversion element, the power generating module further comprises an illumination element, adjacent to the fifth surface of the light-guiding substrate, and used for providing a light beam to the light-guiding substrate, wherein the microstructures guide a part of the light beam to the second surface of the light-guiding substrate to emit out.

24. The power generating module as claimed in Claim 13, wherein the microstructures guide a part of the light beam that arrives at the first surface to the at least one photoelectric conversion element, the power generating module further comprises an illumination element, adjacent to the fifth surface of the light-guiding substrate, and used for providing a light beam to the light-guiding substrate, wherein the microstructures guide a part of the light beam to the at least one photoelectric conversion element.

25. A power generating window set comprising:
a first light transmissible plate;
a second light transmissible plate, opposite to the first light transmissible plate;
and
at least one power generating module as claimed in any of the preceding claims, wherein the light-guiding substrate is disposed between the first light transmissible plate and the second light transmissible plate.
